# EUROPEAN PATENT APPLICATION

(11) **EP 4 664 517 A1**
(43) Date of publication of application: **17.12.2025**
(21) Application number: 24181790.7
(22) Date of filing: 12.06.2024
(51) Int. Cl.: H01L 23/31

(54) **WAFER-LEVEL PACKAGE**

(71) Applicant: Infineon Technologies AG, 85579 Neubiberg (DE)
(72) Inventor: LEUSCHNER, Stephan, 4020 Linz (AT); REIß, Werner, 83064 Raubling (DE); HELLMUND, Oliver, 85579 Neubiberg (DE)
(74) Representative: 2SPL Patentanwälte PartG mbB

(57) **Abstract**

The present disclosure proposes a wafer-level package (200) comprising an integrated circuit (100). The IC (100) includes a wafer (122) and at least one die (102) comprising at least one first transistor (116). The die (102) is mechanically coupled to the wafer (122). The wafer-level package (200) further comprises a package terminal (202). A connection pad (120) is electrically connected to the IC (100). The connection pad (120) has at least a portion which does not overlap with the package terminal (202). A redistribution structure (204) extends between the package terminal (202) and the connection pad (120) and electrically connects the package terminal (202) and the connection pad (120). The IC (100) is electrically connected to the package terminal (202) through the redistribution structure (204) and the connection pad (120).

## Description

### Field

The present disclosure generally relates to integrated circuit design and, more particularly, to the design of Wafer-Level Packages (WLP) which can be used for high voltage RF switches and/or antenna tuners.

### Background

An antenna tuner, also known as an antenna matching unit, is a device which may be used in radio communication systems to match an impedance of a radio transmitter with an antenna. An antenna tuner can include RF switches. RF switches in an antenna tuner may be used to select different components like inductors and capacitors for tuning the antenna to a desired frequency. An RF switch is a device used in radio frequency (RF) communication systems to switch signals between different paths or components. Key components of RF switches are transistors. These act as main switching elements, controlling the signal path based on their on/off state.

Antenna tuners and RF switches can be implemented using Wafer-Level Chip Scale Packaging (WLCSP). WLCSP is a type of packaging technology used in the semiconductor industry. In this approach, the packaging process is integrated into the semiconductor manufacturing process at the wafer level. This means that the chip is packaged while still part of the wafer, before individual chips are cut out. WLCSP allows for a compact package size, nearly equivalent to the size of the die itself. Thus, an antenna tuner can be made nearly the size of the chip itself, optimizing space without compromising functionality.

Antenna tuner designs are constrained by an RF switch transistor area needed to obtain a certain on-resistance value and voltage handling capability. The physical size of the transistors in RF switches is a factor which influences both the on-resistance and the ability of the switch to handle certain voltages. Larger transistor areas can handle higher voltages and have lower on-resistance, but they also take up more space. Three-Dimensional Integrated Circuits (3DIC) may be a way to decrease the on-resistance at a given chip size by stacking two or more silicon dies and bonding them on top of each other. By stacking components vertically, 3DICs may offer a more efficient use of space, allowing for the inclusion of larger transistors without increasing the overall footprint of the circuit. Larger transistors generally have lower on-resistance, which may improve the performance of the RF switch. Additionally, 3DICs can provide shorter interconnections, which may reduce resistance further.

Another parameter in design and operation of antenna tuners is their Off-capacitance. Off-capacitance refers to the capacitance that exists in the RF switch of the tuner when it is in the off state. This capacitance can affect the performance of the tuner, particularly in terms of signal leakage and frequency response. The design of the RF switch, including materials and structure, will influence the level of Off-capacitance.

In integrated circuit design, pad structures are essential for connecting the chip/die to the outside world. These pads, depending on their size and layout, can contribute additional parasitic capacitance. When the RF switch in an antenna tuner is off, this parasitic capacitance from the pads can add to the overall Off-capacitance of the switch. This may result in stronger ballasting needed to obtain the voltage handling and finally in a higher off-state capacitance.

Thus, there is a need of improving the Off-capacitance of antenna tuners or other devices.

### Summary

This need is addressed by wafer-level packages in accordance with the appended claims.

According to a first aspect, the present disclosure provides a wafer-level (chip scale) package. The wafer-level package comprises an integrated circuit (IC). The IC comprises a wafer (e.g., a handling wafer). The IC further comprises a die comprising at least one transistor (e.g., an RF switch transistor). The die is mechanically coupled to the wafer. The wafer-level package comprises a package terminal (e.g., comprising a solder bump). The wafer-level package further comprises a connection pad (e.g., a metal pad) which is electrically connected to the IC. The connection pad has at least a portion which does not overlap with the package terminal. The wafer-level package further comprises a redistribution structure (e.g., a redistribution layer) extending between the package terminal and the connection pad and electrically connecting the package terminal and the connection pad. The IC is electrically connected to the package terminal through the redistribution structure and the connection pad.

Due to a lateral offset between the connection pad and the package terminal, the proposed wafer-level package may reduce a capacitive coupling between the connection pad and the least one transistor, thus improving the trade-off voltage handling vs Off-capacitance.

In some embodiments, the IC further comprises a second die which includes at least one second transistor (e.g., an RF switch transistor). The (first) die and the second die are bonded together through a bonding interface. The (first) transistor of the (first) die and the second transistor of the second die may both be part of the same RF switch, for example.

In some embodiments, the IC is a two-dimensional IC (2DIC) or a three-dimensional IC (3DIC). 2DICS are integrated circuits where all components and connections are built on a single plane, typically a silicon wafer. 3DICs involve stacking multiple semiconductor dies on top of each other, e.g., connected using technologies like Through-Silicon Vias (TSVs) or other bonding methods. This vertical integration may allow for increased performance, reduced power consumption, and more compact designs compared to 2DICs.

In some embodiments, the connection pad exhibits no lateral overlap with the package terminal. That is, the connection pad is laterally completely outside the package terminal. This may further decrease the parasitic capacitance from the connection pad and thus decrease the overall Off-capacitance of the switch.

In some embodiments, the connection pad has a lateral width of less than 60 µm, preferably less than 30 µm, and mor preferably less than 25 µm.

In some embodiments, the package terminal (e.g., solder bump) is arranged so as to laterally overlap with the IC. Thus, the connections from/to the die may be routed inwards (or "fanned-in") towards the center of the wafer-level package, leading to a so-called Fan-In Wafer-Level Package (FI WLP). This may make it possible to fit the package within the footprint of the die. This packaging technology may involve the use of a Redistribution Layer (RDL), which is a layer of metal lines that are used to reroute the electrical connections from the connection pad (e.g., die pads located on the die) to the package terminal (e.g., solder ball located on the package). The RDL may effectively 'fan in' the connections.

In some embodiments, the package terminal is arranged so as to exhibit no lateral overlap with the IC. Thus, the electrical connections of the IC die may be "fanned out," (FO) or extended beyond the boundaries of the die. In FO WLP, the package footprint is larger than the die itself. This is made possible by extending the die's electrical connections outward onto a reconstituted wafer, which provides additional space for placing input/output (I/O) connections. FO WLP uses an RDL to reroute the connections from the die pads to the new I/O locations on the extended package area. This RDL may be more complex than in fan-in technology due to the increased space and routing requirements.

In some embodiments, the wafer-level package further comprises at least one first layer of protective coating material over the redistribution structure. The first layer of protective coating material may be used as a passivation layer on the package surface. The first layer of protective coating material may comprise an opening accommodating the package terminal (e.g., solder ball) therethrough. The portion of the connection pad which does not overlap with the package terminal does also not laterally overlap with the opening of the protective coating material.

In some embodiments, the wafer-level package further comprises at least one second layer of protective coating material between the redistribution structure (e.g., RDL) and the die. Here, the second layer of protective coating material can be used as a base layer onto which the RDL is built. It may provide a stable and reliable foundation for these additional conductive traces and connections.

In some embodiments, the second layer of protective coating material comprises an opening for allowing electrically connecting the connection pad to the redistribution structure therethrough. Thus, the opening of the second layer of protective coating material may laterally overlap with the connection pad.

In some embodiments, the protective coating material comprises polyimide.

In some embodiments, the die of the IC further comprises an ultra-thick metal (UTM) arranged between the connection pad and the least one transistor and electrically coupled to the connection pad. A thickness of the UTM is greater than a thickness of the connection pad. UTM refers to metal layers that are significantly thicker than the standard metal layers used in typical semiconductor manufacturing processes. In semiconductor fabrication, metal layers are used for various purposes, such as forming interconnections between different components on the chip, creating electrodes, or serving as heat sinks. The definition of "ultra-thick" can vary based on the application and the standard processes, but generally, it implies metal layers that are several micrometers thick, often ranging from a few micrometers to tens of micrometers.

In some embodiments, a lateral width of the UTM substantially equals a lateral width of the connection pad. Since the lateral width of the connection pad can be smaller than in conventional designs, the lateral width of the UTM may also get smaller, thus lowering the parasitic capacitance.

In some embodiments, the wafer-level package further comprises an under-bump metallization (UBM) between the package terminal (e.g., solder bump) and the redistribution structure.

In some embodiments, the at least one first transistor of the first die and the at least one second transistor of the second die include first and second switches of an RF switch.

According to a further aspect, the present disclosure provides a wafer-level package comprising a handling wafer and a 3DIC attached to the handling wafer. The 3DIC comprises a first die attached to the handling wafer and comprising a plurality of first transistors of an RF switch circuit. The 3DIC further comprises a second die attached to the first die and comprising a plurality of second transistors of the RF switch circuit. The wafer-level package comprises at least one solder bump, a redistribution layer (RDL) between the solder bump and the second die and electrically connecting the solder bump to the second die. A die pad is provided between the redistribution layer and the second die and electrically connecting the redistribution layer to the second die. The die pad is arranged laterally displaced from the solder bump. The second transistors are arranged between the first die and the metal pad.

According to yet a further aspect, the present disclosure provides an antenna tuner and/or RF switch comprising a wafer-level package according to any one of the previous embodiments.

Some embodiments may improve the OFF-capacitance of antenna tuners by using a combination of 3DIC integration and a fan-in, chip-size package. This combination may reduce the capacitive coupling from package / pad to RF switch, thus improving the voltage handling vs Coff trade-off.

### Brief description of the Figures

Some examples of apparatuses and/or methods will be described in the following by way of example only, and with reference to the accompanying figures, in which
- Fig. 1: shows a cross-sectional view of a 3DIC for use in RF applications;
- Fig. 2-9: show cross-sectional views of the 3D-IC of Figure 1 illustrating sequential process steps of an example manufacturing process;
- Fig. 10: shows a cross-sectional view of a fan-in wafer-level package including a 3DIC according to a first embodiment;
- Fig. 11: shows a cross-sectional view of a fan-in wafer-level package including a 3DIC according to a second embodiment;
- Fig. 12: shows a cross-sectional view of a fan-in wafer-level package including a 3DIC according to a third embodiment;
- Fig. 13: shows a cross-sectional view of a fan-in wafer-level package including a 3DIC according to a fourth embodiment;
- Fig. 14: shows a cross-sectional view of a fan-out wafer-level package including a 3DIC according to a fifth embodiment; and
- Fig. 15: shows a cross-sectional view of a fan-in wafer-level package including a 2DIC according to a sixth embodiment.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

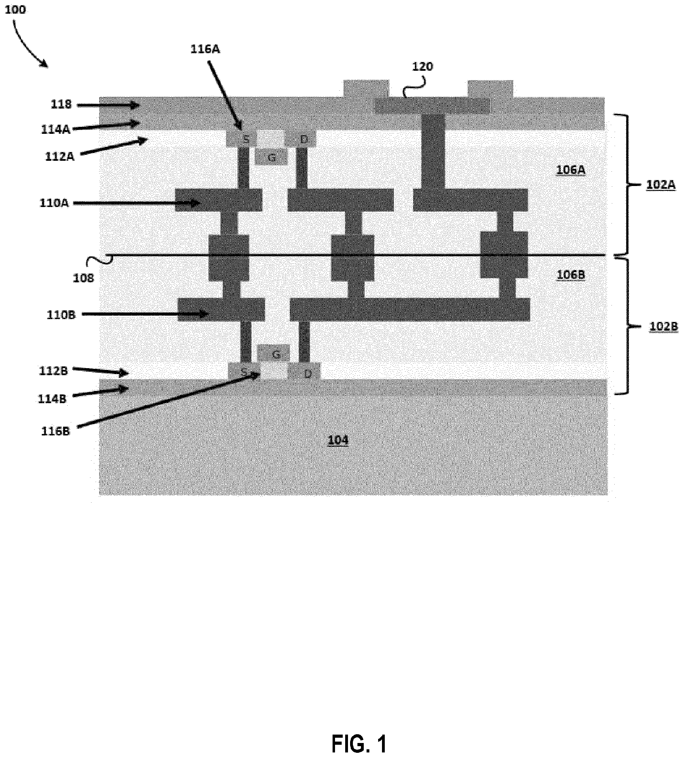

**Fig. 1** is a cross-sectional view of an example 3DIC 100 for use in RF applications. For example, 3DIC 100 may implement an RF switch and/or an antenna tuner.

3DIC is a technology in microelectronics that stacks silicon wafers or dies and interconnects them vertically to form a single integrated circuit. This approach contrasts with traditional flat, 2D chip designs. In a 3DIC, multiple layers of active electronic components are stacked vertically. This is different from traditional 2D ICs where everything is fabricated on a single plane. Vertical integration may allow for a more compact design, reducing the footprint of the chip. Through-Silicon Vias (TSVs) are a key technology in 3DICs. They are conductive pathways that go through the silicon wafers or dies, enabling electrical connections between different layers of the stack. By reducing the distance that electrical signals need to travel between components, 3DICs can operate at higher speeds and with lower power consumption compared to traditional 2D ICs. This may be particularly beneficial for high-performance computing and mobile devices. Stacking layers of components allows for a higher density of transistors within a given footprint. This means more functionality can be packed into a smaller space.

The illustrative 3DIC 100 of Fig. 1 comprises a first die or chip (chip 1) 102A in an upper position, and a second die or chip (chip 2) 102B in a lower position. A mold wafer 104 is attached to a bottom surface of chip 2 102B. Chip 1 102A includes a first dielectric layer 106A, and chip 2 102B includes a second dielectric layer 106B. Chip 1 102A and chip 2 102B are joined together at the exposed surfaces of the first dielectric layer 106A and the second dielectric layer 106B through bond interface 108 which may include TSVs. Chip 1 102A includes a metal wiring layer 1 10A that includes a horizontal metal layer as well as a plurality of vertical metal vias. In some embodiments, chip 1 102A can also include one or more additional metal wiring layers. Chip 2 102A includes a metal wiring layer 110B that includes a horizontal metal layer as well as a plurality of metal vias. In some embodiments, chip 2 102B can also include one or more additional metal wiring layers. Chip 1 102A includes a shallow trench isolation (STI) layer 112A for isolating a plurality of transistors such as RF-transistor 116A. Chip 2 102B also includes a similar shallow trench isolation (STI) layer 112B for isolating a plurality of transistors such as RF-transistor 116B. Chip 1 102A further includes a first buried oxide (BOX) layer 114A, and chip 2 102B further includes a similar buried layer, second buried oxide (BOX) layer 114B. In an embodiment, chip 1 102 is passivated with passivation layer 118, and can include one or more metal pads, such as die pad 120.

The silicon handling wafer of chip1 102A (not shown in Fig. 1 and described in greater detail below) may be finally removed down to the first buried oxide (BOX) layer 114A. In some embodiments, the silicon handling wafer of chip 2 is typically not removed. To ensure RF performance, an expensive trap-rich-high-resistivity wafer (TR-HR-Wafer) may be used as substrate for chip 2.

A performance of the 3DIC 100 may be increased by removing the silicon handling wafer below chip 2 102 and bonding chip 2 102B to mold wafer 104. Other materials such aluminum nitride AlN, aluminum oxide Al2O3, or glass (SiO₂) can also be used instead of the mold wafer 104. Advantageously RF performance can be increased but a cost reduction may also be realized, because a more cost effective SOI-wafer can be used instead of the expensive TR-HR-Wafer in some embodiments. In some embodiments process acts to provide a substrate contact can also be skipped for further cost reductions.

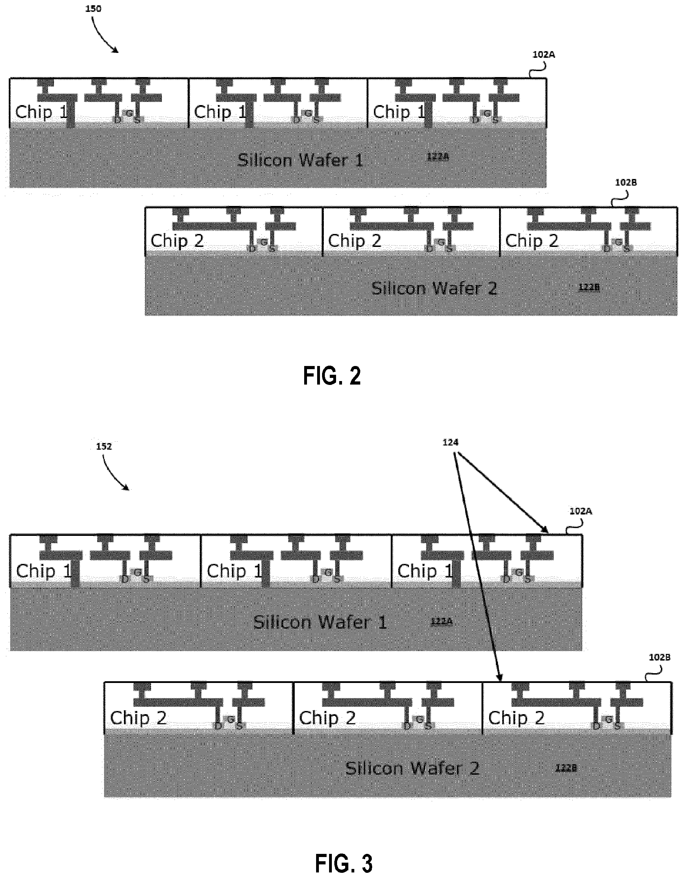

An example manufacturing flow for the 3DIC 100 is described below with respect to sequential processing steps shown in cross-sectional views in Figs. 2 to 9.

**Fig. 2** illustrates a first processing step 150, wherein a plurality of first chips chip 1 102A and a plurality of second chips chip 2 102B are manufactured on corresponding different SOI doped silicon handing wafers 122A, 122B. These SOI doped silicon handling wafers are less expensive than specialty RF handling wafers. Silicon wafer 1 122A includes a plurality of identical chips of chip 1 102A. As previously described, chip 1 102A comprises circuitry portions of an RF-switch and/or an RF-tuner. Silicon wafer 2 122B includes a plurality of identical chips of chip 2 102B. As previously described, chip 2 102B comprises different circuitry portions of an RF-switch and/or an RF-tuner, such that the combination of chip 1 102A and chip 2 102B encompass all of the circuit components of the RF-switch and/or RF-tuner.

**Fig. 3** illustrates a second processing step 152, wherein silicon wafer 1 122A and silicon wafer 2 122B are prepared for wafer bonding. In particular, the top surface 124 of the plurality of chips (chip 1 102A and chip 2 102B) may be polished to achieve smooth top surfaces.

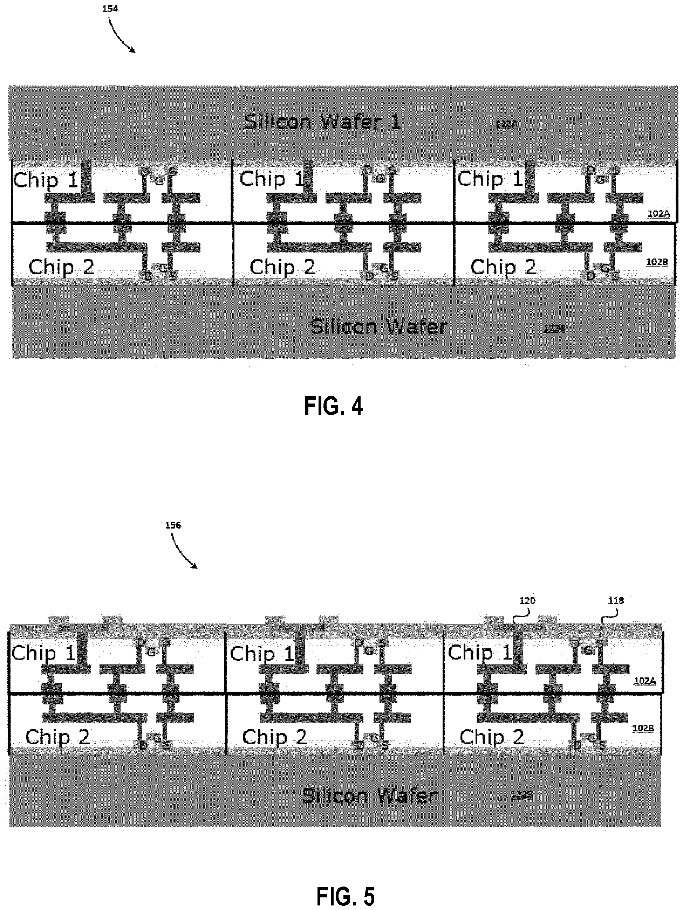

**Fig. 4** illustrates a third processing step 154, wherein silicon wafer 1 122A and silicon wafer 2 122B are bonded together. In an embodiment, silicon wafer 1 122A is vertically flipped and precisely aligned onto silicon wafer 2 122B, such that all corresponding metal contact points are properly arranged. In third processing step 154, plasma activation may be used to prepare the polished surfaces of silicon wafer 1 122A and silicon wafer 2 122B for bonding. Bonding at bond interface 108 may be accomplished using a hybrid bonding tool.

**Fig. 5** illustrates a fourth processing step 156, wherein silicon wafer 1 122A is removed by grinding and/or etching down to the first BOX layer 114A. Once silicon wafer 1 122A has been removed, depositing and structuring of pad-metallization for die pad 120 may be performed. Once one or more die pads are formed, depositing and structuring of passivation layer 118 may be performed.

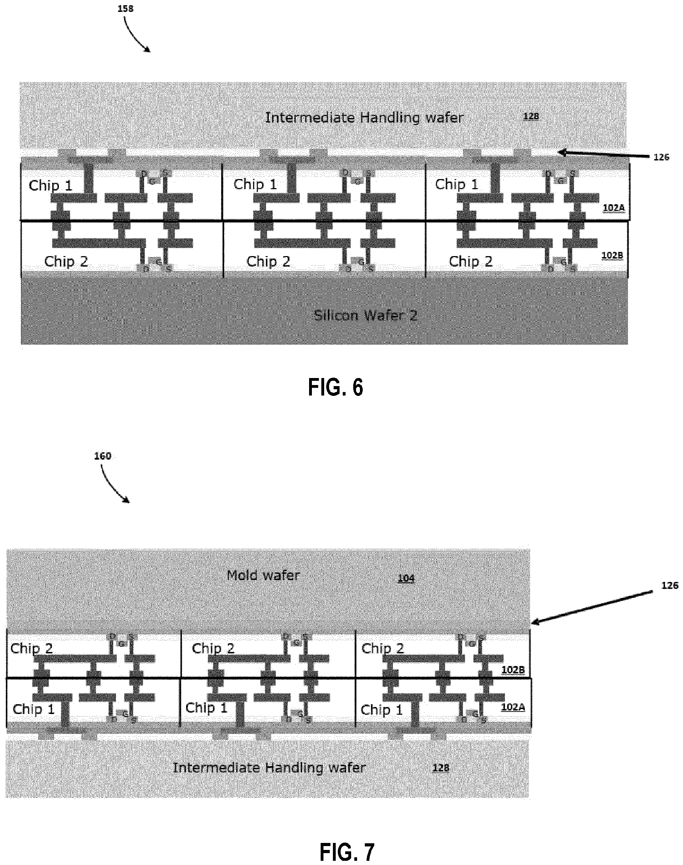

**Fig. 6** illustrates a fifth processing step 158, wherein an intermediate handling wafer 128 (e.g. a glass wafer) may be mounted on the top side of the plurality of chips (chip 1 102A) using an adhesive tape or glue layer 126A. Processing step 158 is optional and may be omitted.

**Fig. 7** illustrates a sixth processing step 160, wherein the plurality of mounted wafers are flipped, and silicon wafer 2 122B is removed. The removal can be implemented, for example, by grinding and/or etching down to second BOX layer 114B. A new handling wafer is mounted on the new top side of the mounted wafers (top surface of flipped chip 2 102B). In some embodiments, the new handling wafer can comprise a mold wafer 104 of a wafer comprising aluminum nitride (AlN), Aluminum oxide (Al₂O₃), or glass (SiO₂). The new handling wafer 104 can be mounted by using a glue layer 126B or an adhesive tape. Processing step 160 is optional and may be omitted.

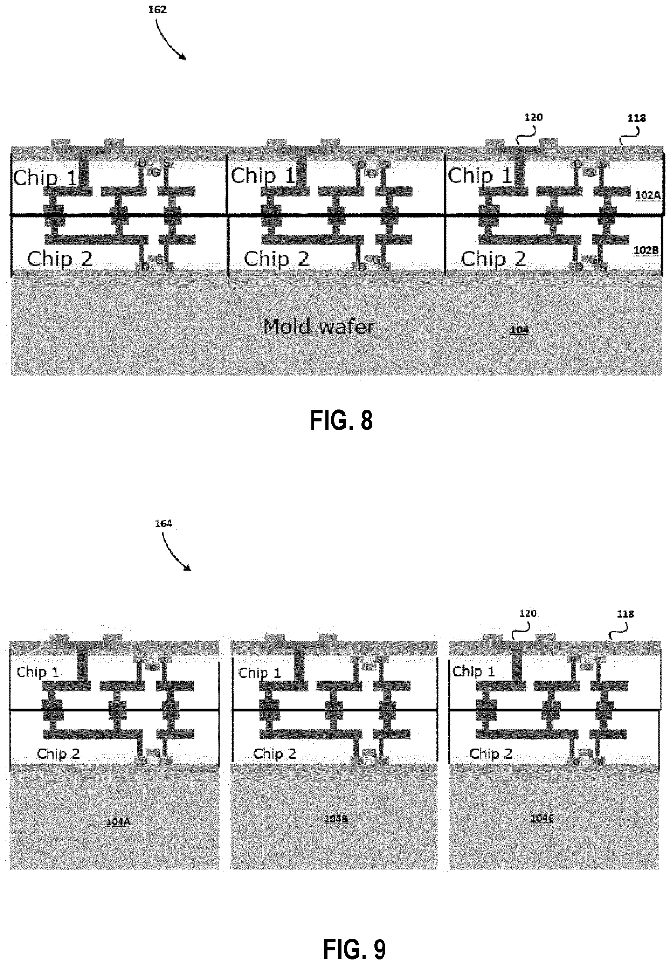

**Fig. 8** illustrates a seventh processing step 162, wherein the mounted wafers are flipped again to the original orientation, and the intermediate handling wafer 128 is removed. Once the intermediate handling wafer 128 is removed, the top surface of the plurality of chips (chip 1 102A) is cleaned. Processing step 162 is optional and may be omitted.

**Fig. 9** illustrates an eighth processing step 164, wherein singularization of the individual bonded chips (chip 1 102A and chip 2) and corresponding portions of the mold wafer (104A, 104B, and 104C) or Silicon wafer 122B is performed. Singularization can be performed, for example, by sawing, laser cutting, or etching.

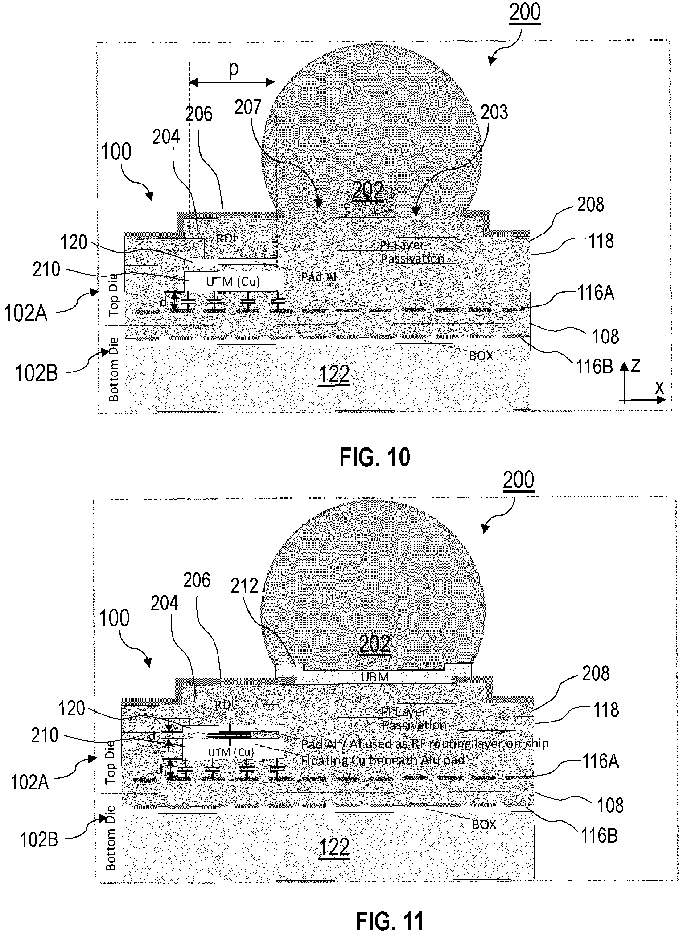

The individual 3DICs can then be packaged into individual wafer level packages or fabricated in a hybrid circuit along with other supporting components (not shown). An example of a resulting individual wafer level package (WLP) 200 is shown in **Fig. 10****.**

The WLP 200 comprises an integrated circuit (IC). In the example of Fig. 10, the IC is a 3DIC, such as 3DIC 100. Embodiments are not limited to 3DICs. The skilled person having benefit from the present disclosure will appreciate that the IC could also be a 2DIC.

The 3DIC 100 of WLP 200 shown in Fig. 10 comprises a wafer, such as a Silicon wafer 122, mold wafer 104, or a handling wafer. The 3DIC 100 further comprises a (bottom) die 102B sitting on top of wafer 122 and comprising a first plurality of RF switch transistors 116B of an RF switch. Bottom die 102B is mechanically coupled to wafer 122. Wafer 122 acts as substrate for (bottom) die 102B. 3DIC 100 further comprises a (top) die 102A sitting on top of die 102B and comprising a second plurality of RF switch transistors 116A of the RF switch. The dies 102A and 102B are stacked on top of each other and bonded together through bonding interface 108. 3DIC 100 may implement an RF switch and/or antenna tuner, for example.

WLP 200 shown in Fig. 10 further comprises at least one package terminal 202. The package terminal 202 may provide a pathway for electrical signals to travel between the WLP 200 and external circuitry. It acts as a conduit for input and output signals necessary for the WLP's 200 operation. Package terminal 202 may comprise a solder bump. The solder bump is a small ball of solder that may provide electrical connection between the WLP 200 and a substrate, such as a PCB (Printed Circuit Board), or another chip. Other examples of package terminals 202 include wire bonds, pads for surface mounting, Ball Grid Arrays (BGA), etc.

The 3DIC 100 of WLP 200 shown in Fig. 10 further comprises at least one die pad 120 (e.g., a metal pad) which is electrically connected to top die 102A and thus to 3DIC 100. Die pads, also known as bond pads or chip pads, may serve as the primary interface for electrical connection between the 3DIC 100 and the outside world. The primary function of die pads is to provide electrical connections for the integrated circuit (IC) (e.g., RF switch transistors 116A) on the 3DIC 100. Each pad may be connected to a specific part of the circuit within the die and allows for the transfer of electrical signals (such as power, ground, and data) between the IC and external circuits. Die pad 120 may be made of materials that have high electrical conductivity, such as Aluminum (Al), Copper (Cu), etc.

According to the present disclosure, the die pad 120 has at least a portion "*p*" which does not (laterally) overlap with the package terminal 202. In other words, die pad 120 and package terminal 202 are laterally displaced such that all or at least a portion p of the die pad 120 is placed laterally outside the package terminal 202. Put still differently, portion *p* of the die pad 120 exhibits no overlap with an electrically conductive interface 203 of the package terminal 202 (or of a metallization located under the package terminal 202) with a redistribution structure 204 of WLP 200 to which the package terminal 202 is electrically connected, as described below. The interface 203 could also be referred to as transition area where the package terminal 202 transitions to and contacts the redistribution structure 204. In Fig. 10, the lateral direction is denoted by "x". In other words, the portion p in question of the die pad 120 does not overlap with the package terminal 202 along a direction which is orthogonal to the main surfaces (i.e. top and bottom surfaces) of the WLP 200, this direction being noted "z" in Figure 10.

In an embodiment, such as that of Figure 10, the passivation layer 118 includes an opening in which or against which the die pad 120 is arranged. The portion p of the die pad 120 stretches from, on the hand, the distal edge of the opening of the passivation layer 118 relative to the interface 203 to, on the other hand, either the opposite (proximal) edge of the opening of the passivation layer 118 when the portion p exhibits no overlap with the package terminal 202/interface 203, or, in case of overlap, to the projection of the edge of the package terminal 202/interface 203 on the die pad 120 along direction "z". In other words, the distal end of the portion p relative to the package terminal 202 is at the edge of the opening of the passivation layer 118 that accommodates the die pad 120, and the proximal end of the portion p relative to the package terminal 202 is either the opposite edge of the passive layer 118 (in case of no overlap) or faces the edge of the package terminal 202/interface 203 along direction z.

In an alternative embodiment, the distal end of the portion p relative to the package terminal 202 is the distal end of the die pad 120 itself (relative to the package terminal 202/interface 203).

In the embodiment illustrated in Fig. 10, the whole die pad 120 exhibits no lateral overlap with the package terminal 202, i.e., the die pad 120 exhibits no overlap with the electrically conductive interface 203 between the redistribution structure 204 and the package terminal 202. In other words, die pad 120 and package terminal 202 are laterally displaced such that all of the die pad 120 is placed laterally outside the electrically conductive interface 203 between the redistribution structure 204 and the package terminal 202.

The pad 120 may have a lateral width (in x-direction) of less than 60 µm, preferably less than 30 µm, and more preferably less than 25 µm. A thickness of the die pad 120 may be 1 to 2 µm for example. In this way, a capacitive coupling between the package terminal 202 and the plurality of RF switch transistors 116A, 116B may be reduced, thus improving the trade-off voltage handling versus Off-capacitance.

The redistribution structure 204 shown in Fig. 10 comprises one or more redistribution layers (RDLs) extending between package terminal 202 and the laterally offset die pad 120. Redistribution structure 204 is arranged vertically between package terminal 202 and offset die pad 120. In Fig. 10, the vertical direction is denoted by "z". Redistribution structure 204 provides electrical connection between package terminal 202 and laterally offset die pad 120. Thus, 3DIC 100 including dies 102A, 102B is electrically connected to package terminal 202 through die pad 120 and redistribution structure 204 coupling die pad 120 to package terminal 202. In many ICs, the die pads 120 are not in a layout that is conducive to direct connection with the package's external package terminals 202. Redistribution structure 204 may provide the necessary re-routing to align these connections appropriately. This may be especially important in high-density packages where the die pad pitch is much finer than what can be reliably handled on a PCB.

Redistribution structure 204 may be electrically isolated from top die 102A by one or more layers 118, 208 of protective coating material between redistribution structure 204 and the top die 102A. The one or more layers 118, 208 of protective coating material can be used as base layers onto which the RDL 204 is built. In the illustrated example, layers 118, 208 include passivation layer 118 (e.g., SiO₂, Si₃N₄) on top of die 102A and polyimide (PI) layer 208 on top of passivation layer 118. These layers 118, 208 may provide a stable and reliable foundation for the additional conductive traces and connections of redistribution structure 204. The layers 118, 208 have an opening to enable the electrical contact between redistribution structure 204 and die pad(s) 120 therethrough. The opening consequently also has at least a portion which does not (laterally) overlap with the package terminal 202.

As shown in the example of Fig. 10, the WLP 200 may further comprise a layer 206 of protective coating material over the redistribution structure 204. The layer 206 of protective coating material may be used as a passivation layer on the package surface. The layer 206 of protective coating material may be a polyimide (PI) layer and/or may comprise an opening 207 accommodating the package terminal (e.g., solder ball) therethrough. In other words, the layer 206 has an opening 207 to enable the electrical contact between the package terminal 202 and redistribution structure 204. The opening 207 provides the electrically conductive interface 203 between the redistribution structure 204 and the package terminal 202. In some embodiments, the opening 207 in layer 206 may provide the package terminal 202 as it provides electrical contact between WLP 200 and the outside. Since the portion p of the die pad 120 does not laterally overlap with the package terminal 202, the portion p of the die pad 120 also does not laterally overlap with the opening 207 of the protective coating material 206 either.

In the example of Fig. 10, the top die 102A of 3DIC 100 further comprises an ultra-thick metal (UTM) 210 arranged in the die 102A between the die pad 120 and the RF transistors 116A. UTM refers to metal layers that are significantly thicker than the standard metal layers 110A, 110B used in typical semiconductor manufacturing processes. While standard metal layers in semiconductor devices might range from a few nanometers to a few micrometers in thickness, UTMs 210 can be several micrometers to tens of micrometers thick, e.g., 2 µm to 20 µm. Common materials for UTMs include copper, aluminum, and sometimes gold or silver. In power electronics, such as RF switches, UTMs may be used to handle high current densities. They may reduce resistive losses and improve heat dissipation. UTM 210 is directly electrically coupled to the die pad 120, for example by means of connecting vias. A thickness of the UTM 210 is greater than a thickness of the die pad 120.

A lateral width of the UTM 210 underneath the die pad 120 may substantially be equal to the lateral width of the die pad 120. Since the lateral width of the die pad 120 can be smaller than in conventional designs, the lateral width of the UTM 210 may also get smaller, thus lowering the parasitic capacitance.

In the example of Fig. 10, the package terminal (e.g., solder bump) 202 is arranged so as to laterally overlap with the top die 102A or 3DIC 100. Thus, the connections from/to the die 102A may be routed inwards (or "fanned-in") towards a center of the WLP, leading to a so-called Fan-In Wafer-Level Package (FI WLP).

As shown in the example implementation of **Fig. 11**, the WLP 200 may further comprise a metallization (UBM) 212 between the package terminal 202 and the redistribution structure 204. For instance, the metallization 212 may be known as an under-bump metallization in the case of a solder bump 202. The metallization 212 serves as an intermediary layer between the solder bump 202 and redistribution structure 204. Metallization 212 may help in adhering the solder bump 202 to the redistribution structure 204. Solder may bond well directly to the materials used for redistribution structure 204 (like aluminum or copper), so metallization 212 may acts as a compatible surface for the solder to adhere to. The metallization 212 may be composed of one or multiple layers.

As further shown in the example of Fig. 11, the UTM 210 may be indirectly electrically coupled to the die pad 120 by means of capacitive coupling. Here, a (vertical) distance between UTM 210 and die pad 120 may be smaller than a (vertical) distance between UTM 210 and transistors 116A below UTM 210.

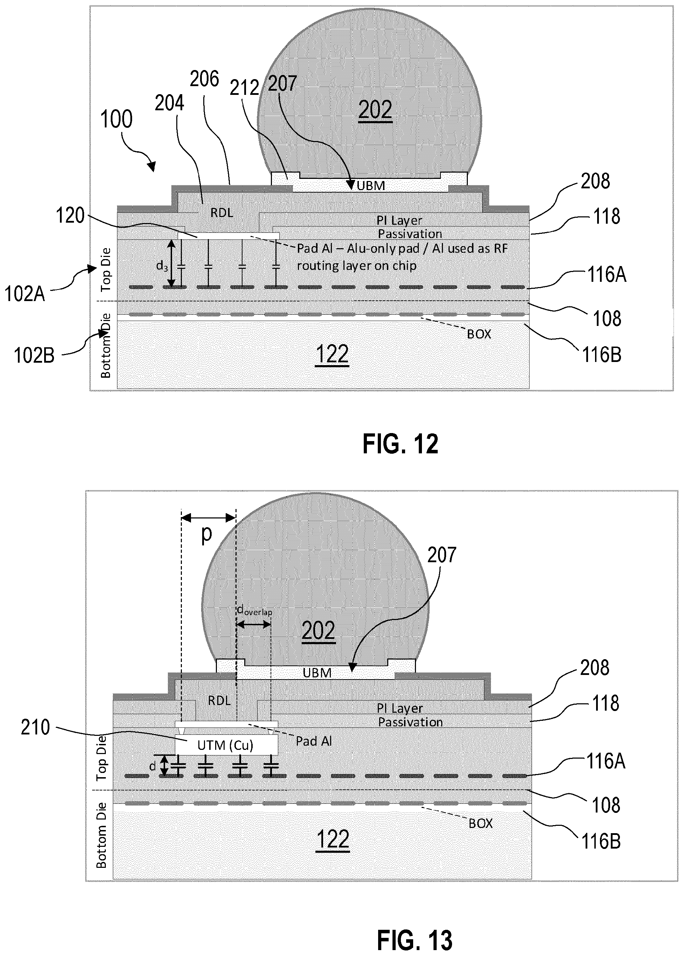

As the die pad 120 is not placed underneath the package terminal (e.g., solder bump) 202 according to embodiments, less structural support may be needed. Therefore, the proposed structure with the laterally offset die pad 120 may also allow to omit the UTM 210 underneath the die pad 120. Such an example is shown in **Fig. 12****.** Due to the omission of UTM 210 between die pad 120 and transistors 116A, a parasitic capacitance may be further reduced, leading to a smaller Off-capacitance of the RF switch or antenna tuner.

While Figs. 10 to 12 illustrate examples with no lateral overlap between die pad 120 and package terminal 202 (or opening 207 of protective coating layer 206), **Fig. 13** shows an example with a lateral overlap between die pad 120 and package terminal 202 (or opening 207 of protective coating layer 206). However, the left portion *p* of the die pad 120 still does not laterally overlap with package terminal 202 (or opening 207). In other words, a left edge of the die pad 120 is still located laterally outside the package terminal 202 (or opening 207). Such an embodiment still exhibits lower mechanical stress compared to an implementation with full lateral overlap between die pad 120 and package terminal 202 (or opening 207).

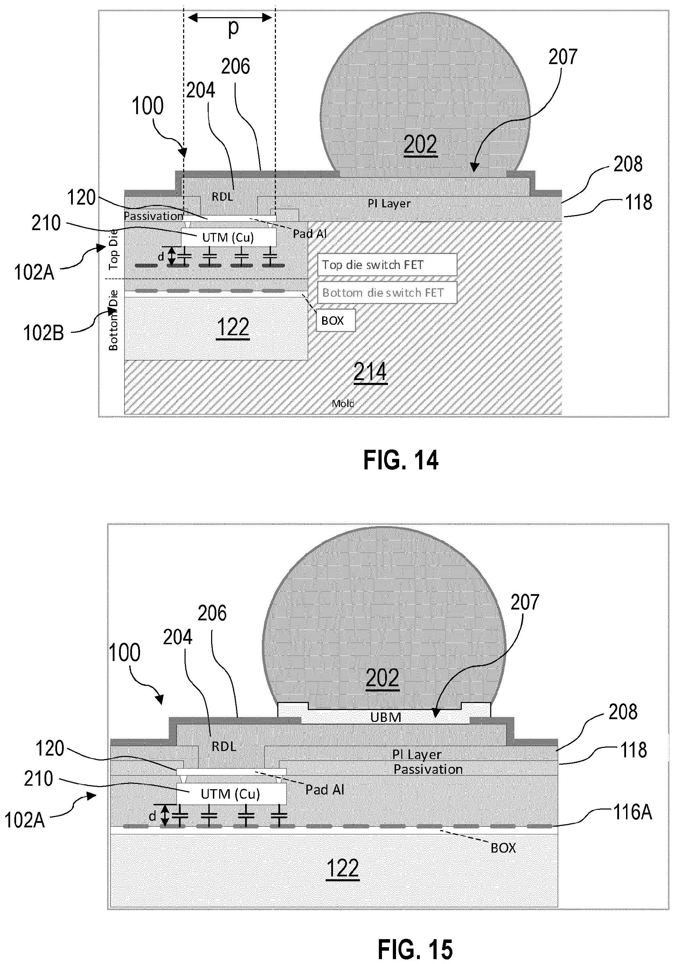

In the embodiment shown in **Fig. 14** the package terminal 202 is arranged so as to exhibit no lateral overlap with the 3DIC 100. The package terminal 202 is arranged laterally outside the 3DIC 100. Thus, the electrical connections of the 3DIC 100 may be "fanned out," (FO) or extended beyond the lateral boundaries of the 3DIC 100 including dies 102A, 102B. In FO WLP, the package footprint is larger than the 3DIC 100 itself. This is made possible by extending the 3DIC 100 electrical connections outward onto a reconstituted wafer 214, which provides additional space for placing input/output (I/O) connections. FO WLP uses may also use redistribution structure 204 to reroute the connections from the die pad(s) 120 to the new I/O locations on the extended package area. This redistribution structure 204 may be more complex than in fan-in technology due to the increased space and routing requirements.

As mentioned before, the IC of WLP 200 does not have to be a 3DIC but could also well be a 2DIC comprising only one die 102A or multiple dies arranged two-dimensionally (i.e., laterally adjacent to each other). Such an example of WLP 200 is schematically illustrated in **Fig. 15****.**

Some embodiments of the present disclosure may combine 3DIC device technology with a fan-in WLP chip-size package for antenna tuners. This combination may leverage the benefits of 3DIC integration while minimizing the detrimental effects of the pad construction needed for WLP type CSP package by:
- reducing the required pad size and thus reducing the capacitive coupling between pad and RF switch FET stack,
- allowing to freely place the pads independently of the package bump placement to further reduce capacitive coupling,
- reducing direct mechanical stress from the ball via the under-ball metallization (UBM) to the pad which (potentially) allows the use of aluminum-only pads, again further reducing the capacitive coupling.

Instead of using a large pad diameter, e.g. 90 µm, with the UBM and the ball of the package directly placed on top, the proposed combination may re-use the UBM as re-distribution layer. A first polyimide (PI) layer may be used to structure the pad opening for a much smaller pad (e.g. 54µm diameter) which is placed outside the ball area. For the proposed solution, an additional PI layer may be needed to define the ball drop area.

The aspects and features described in relation to a particular one of the previous examples may also be combined with one or more of the further examples to replace an identical or similar feature of that further example or to additionally introduce the features into the further example.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several sub-steps, - functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. A wafer-level package (200), comprising
an integrated circuit (100), IC, the IC including,
a wafer (122);
at least one die (102A) comprising at least one first transistor (116A), the die (102 A) being mechanically coupled to the wafer (122);
a package terminal (202);
a connection pad (120) electrically connected to the IC (100), the connection pad (120) having at least a portion (p) which does not overlap with the package terminal (202), and
a redistribution structure (204) extending between the package terminal (202) and the connection pad (120) and electrically connecting the package terminal (202) and the connection pad (120),
the IC (100) being electrically connected to the package terminal (202) through the redistribution structure (204) and the connection pad (120).

2. The wafer-level package (200) of claim 1, wherein the IC (100) is a three-dimensional IC further comprising a second die (102B) which includes at least one second transistor (116B), the die (102A) and second die (102B) being bonded together through a bonding interface (108).

3. The wafer-level package (200) of claim 1, wherein the IC (100) is a two-dimensional IC.

4. The wafer-level package (200) of any one of the previous claims, wherein the connection pad (120) exhibits no lateral overlap with the package terminal (202).

5. The wafer-level package (200) of any one of the previous claims, wherein the package terminal (202) is arranged so as to laterally overlap with the IC (100).

6. The wafer-level package (200) of any one of claims 1 to 4, wherein the package terminal (202) is arranged so as to exhibit no lateral overlap with the IC (100).

7. The wafer-level package (200) of any one of the previous claims, further comprising
at least one first layer (206) of protective coating material over the redistribution structure (204), the first layer (206) of protective coating material comprising an opening (207) accommodating the package terminal (202) therethrough, said portion of the connection pad (120) not laterally overlapping with the opening (207).

8. The wafer-level package (200) of any one of the previous claims, further comprising
at least one second layer (118; 208) of protective coating material between the redistribution structure (204) and the die (102A).

9. The wafer-level package (200) of claim 8, wherein the second layer (118; 208) of protective coating material comprises an opening for allowing electrically connecting the connection pad (120) to the redistribution structure (204) therethrough.

10. The wafer-level package (200) of any one of claims 6 to 9, wherein the protective coating material comprises polyimide.

11. The wafer-level package (200) of any one of the previous claims, wherein the die (102A) of the IC (100) further comprises
an ultra-thick metal, UTM (210), arranged between the connection pad (120) and the least one first transistor (116) and electrically coupled to the connection pad (120), wherein a thickness of the UTM (210) is greater than a thickness of the connection pad (120).

12. The wafer-level package (200) of claim 11, wherein a lateral width of the UTM (210) equals a lateral width of the connection pad (120).

13. The wafer-level package (200) of any one of the previous claims, further comprising
an under-bump metallization, UBM (212), between the package terminal (202) and the redistribution structure (204).

14. The wafer-level package (200) of any one of the previous claims, wherein the at least one first transistor (116A) of the die (102A) and the at least one second transistor (116B) of the second die (102B) include first and second switches of a radio frequency, RF, switch.
